# EUROPEAN PATENT APPLICATION

(11) **EP 0 973 189 A2**
(43) Date of publication of application: **19.01.2000**
(21) Application number: 99202295.4
(22) Date of filing: 13.07.1999
(51) Int. Cl.: H01L 21/28, H01L 29/51

(54) **A method for gate-stack formation including a high-K dielectric**

(30) Priority: 15.07.1998 US 92909 P
(71) Applicant: Texas Instruments Incorporated, Dallas, Texas 75251 (US)
(72) Inventor: Hattangady, Sunil V., McKinney, Texas 75070 (US); Brown, George A., Arlington, Texas 76012 (US); Bevan, Malcom J., Garland, Texas 75044 (US)
(74) Representative: Holt, Michael

(57) **Abstract**

A gate stack (104) including a gate dielectric with reduced effective electrical thickness. A thin (e.g., ∼ 15 Angstroms) silicon dioxide layer is formed on a substrate (102). Remote plasma nitridation of the silicon dioxide layer is performed to create a silicon-oxynitride layer (106) that is resistant to oxidation. A oxygen-containing high-K dielectric (108) is formed over the silicon-oxynitride layer (106) without additional oxidation of the layer (106). The gate electrode (110) is then formed over the high K dielectric (108).

## Description

### FIELD OF THE INVENTION

The present application is generally related to the field of MOSFET transistors and more specifically to gate stack formation including a high-K gate dielectric.

### BACKGROUND OF THE INVENTION

Presently, there is a great demand for shrinking semiconductor devices to provide an increased density of devices on the semiconductor chip that are faster and consume less power. The scaling of devices in the lateral dimension requires vertical scaling as well so as to achieve adequate device performance. This vertical scaling requires the effective electrical thickness of the gate dielectric to be reduced so as to provide the required device performance.

Silicon dioxide has been the preferred gate dielectric material. However, newer technologies are requiring effective thickness of the silicon dioxide below currently achievable limits (e.g., < 10 Angstroms). Therefore, there is interest in using higher dielectric constant (high-K) materials such as tantalum pentoxide and barium-strontium-titanate. Using a higher-K material allows for a greater physical thickness while obtaining a lower effective electrical thickness.

Unfortunately, most of the high-K materials being considered contain oxygen and/or are formed in an oxygen ambient. Therefore, during formation, silicon dioxide is formed on the surface of the substrate between the high-K dielectric and the substrate. The thickness of the silicon dioxide is such that much of the advantage to be obtained with the high-K material is lost.

High-K dielectrics are also being evaluated for memory applications as a storage capacitor cell dielectric. In one prior art application, ammonium nitridation is using to form a nitride layer over silicon as a barrier to further oxidation during high-K dielectric formation. The high-K material is then formed over the nitride barrier layer. However, the nitride barrier layer has a high interface state density that is detrimental for gate dielectric applications.

### SUMMARY OF THE INVENTION

The method and apparatus disclosed herein use remote plasma nitridation (RPN) of a thin silicon dioxide layer prior to high-K dielectric formation. The RPN inhibits oxidation during the high-K dielectric formation resulting in a gate dielectric having a thinner effective electrical thicknesses.

An advantage of this approach is providing a gate dielectric having a reduced effective electrical thickness.

### BRIEF DESCRIPTION OF THE DRAWINGS

The present invention will now be further described, by way of example, with reference to certain exemplary embodiments illustrated in the accompanying drawings in which:
FIG. 1 is a cross-sectional diagram of a transistor having gate dielectric; and
FIGs. 2A-2D are cross-sectional diagrams at various steps in the fabrication of the transistor of FIG. 1.

### DETAILED DESCRIPTION OF THE EMBODIMENTS

The method disclosed herein will now be described in conjunction with a 0.1micron MOSFET transistor. It will be apparent to those of ordinary skill in the art that the benefits can be applied to other transistor sizes with appropriate scaling of the dimensions described herein. The benefits can also be applied to transistor structures different from that described below, such as those transistors having raised source/drain regions.

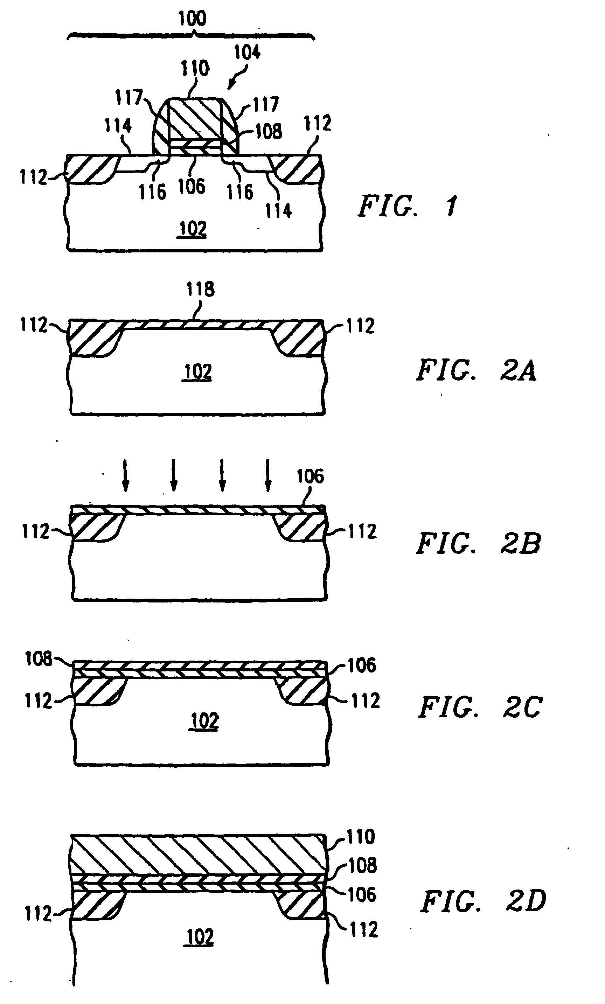

A MOSFET transistor 100 having a gate stack 104 is shown in FIG. 1. Transistor 100 is located in semiconductor body 102 and is separated from other transistors (not shown) by isolation regions 112. As shown isolation regions 112 are shallow trench isolation. However, other isolation mechanisms known in the art may alternatively be used. Source/drain regions 114 and drain extension regions 116 are located in the semiconductor body 102 on opposite sides of gate stack 104.

Gate stack 104 comprises a multi-layer gate dielectric. The first layer is a silicon-oxynitride layer 106. It has a physical thickness on the order of 15 Angstroms and a dielectric constant greater than that of silicon dioxide (∼4) and less than that of silicon nitride (∼7). Overlying silicon-oxynitride layer 106 is a high-K dielectric layer 108. High-K is used herein to refer to a dielectric material having a dielectric constant greater than 10. Layer 108 will typically comprise an oxygen-containing high-K dielectric material such as Ta2O5, BaTiO3, TiO2, CeO2, or BST. However, layer 108 may alternatively comprise a high-K material that is formed using a process that allows oxygen from another source to enter the environment. The thickness of high-K layer 108 is on the order of 90 Angstroms. Thus, the total effective electrical thickness of the gate dielectric is on the order of 15-20 Angstroms of silicon dioxide.

Gate stack 104 further comprises a gate electrode 110 overlying the high-K layer 108. Gate electrode 110 preferably comprises metal as polysilicon tends to form an additional layer of silicon dioxide over the oxygen-containing high-K dielectric. The metal chosen may need to be matched to the dielectric layer 108 in terms of process integration and its work function that ultimately dictates the threshold voltage of the device. For example, gate electrode 110 may comprise tungsten, aluminum, or copper in conjunction with a barrier layer such as TiN. In the preferred embodiment, the high-K layer 108 comprises Ta2O5 and the gate electrode 110 comprises a layer of tungsten (W) overlying a layer of titanium-nitride (TiN).

A method for forming gate stack 104 according to stet of the present teachings will now be described. A thin silicon dioxide layer 118 is formed over the surface of semiconductor body 102 as shown in FIG. 2A. Layer 118 has a thickness on the order of 15 Angstroms. Layer 118 may be as thin as possible while still obtaining a continuous layer of oxide. The maximum thickness for layer 118 depends on the desired electrical thickness of the final gate dielectric. For practical purposes, this may be 15-20 Angstroms for a 0.10 micron technology.

Referring to FIG. 2B, silicon dioxide layer 118 is subjected to a remote plasma nitridation (RPN). RPN converts layer 118 from silicon dioxide to silicon-oxynitride layer 106. The effective electrical thickness of layer 106 is decreased due to a change in the dielectric constant of the material. Silicon oxynitride layer 106 has a physical thickness on the order of 15 Angstroms and a dielectric constant greater than that of silicon dioxide (∼4) and less than that of silicon nitride (∼7).

The source of nitrogen for the plasma may be a nitrogen containing precursor such as N₂ or NH₃ or their mixture with any other inert gas (He, Ar, etc.) or oxidizing gas (NO, N₂O, O₂, etc.). The plasma is preferably a high density plasma. The plasma may be generated by any one of a number of sources. For example, one of the following sources may be used: helicon; helical-resonator; electron-cyclotron resonance; or inductively coupled. The substrate 102 can be unbiased, in which case the ionized substances are accelerated by the plasma potential (on the order of 20 volts) and then implanted into the silicon dioxide layer 118 surface. A bias can be applied to the substrate 102 to further accelerate the ions from the plasma and implant them deeper into the surface. Either a DC or RF bias may be applied to the substrate 102. As an example, the following process conditions may be used: plasma density between 1x10¹⁰ to 1x10¹²; nitrogen flow between 1 and 100 sccm; pressures on the order of 1 to 50 mTorr, temperature in the range of 77 K to 773 K (500·C); substrate bias in the range of 0 to 50 Volts; and a duration in the range of 10 to 60 seconds.

After RPN, high-K dielectric layer 108 is formed over silicon oxynitride layer 106 as shown in FIG. 2C. Layer 108 will typically comprise an oxygen-containing high-K dielectric material such as Ta2O5, BaTiO2, TiO2, CeO2, or BST. However, layer 108 may alternatively comprise a high-K material that is formed using a process that allows oxygen from another source to enter the environment. The method for forming high-K dielectric layer 108 will vary depending on the material used. Improved methods for depositing many of these materials are currently being developed.

In a preferred embodiment of the present teachings, Ta2O5 is used as layer 108. It may be formed in the following manner using a LPCVD process. After RPN, the device is loaded into a furnace at low temperature (e.g., ∼300°C). The wafers are preferably placed in alternating slots of a ring boat with side dummy wafers at the ends. The boat and side dummy wafers should be coated with at least 100 Angstroms of TaO5, otherwise thickness uniformity may be a problem.

After loading, the furnace pump is purged and the temperature is ramped to the deposition temperature (i.e., on the order of 410-450°C) and stabilized before the reactive gases are introduced. N2 or NR3 may be used as a carrier gas during the heating phase. NH3 may ensure that the surface stays nitrided.

A metalorganic source is then introduced to react with oxygen at low pressure for deposition. Metalorganic sources include tantalum pentaethoxide (TAETO) or tantalum tetraethoxide (TATDMAE). The tantalum sources are viscous liquids and could be supplied in bubblers with a carrier gas such as N2 bubbled through to carry the tantalum to the furnace. However, the bubbler would have to be operated at 120-150°C and long-term stability may be a problem. A preferred delivery technique is to use a positive displacement or CVD pump. The tantalum source is then dispensed to a heated vaporizer and mixed with a carrier gas such as N2 and then delivered to the furnace. Alternatively, the tantalum source may be supplied via a liquid MFC (mass flow controller) that injects the source liquid into the heated vaporizer.

Exemplary deposition conditions are:
- Pressure:: 0.1 to 1 Torr (typically 0.2-0.3 Torr)
- TAETO flow:: 0.1 to 1.0cc/min (typically 0.2-0.4 cc/min)
- O2 flow:: 500-1000 sccm (typically 1000 sccm)
- N2 carrier flow:: 500-1000 sccm (typically 750 sccm)
- Temperature:: 410-450°C
- Time:: on the order of 10 minutes with a growth rate of 10-15Å/min.

After deposition, the furnace tube is cycle purged to remove any TAETO before cooling down to unload temperature and to bring the chamber back to atmospheric pressure. The overall process takes approximately 3-4 hours. Alternatively, a RTP process may be used with temperatures of 400-500°C and shorter duration.

The formation of high-K layer 108 may be followed by an optional anneal to reduce leakage and provide for a robust interface. For example, the device may be annealed in nitrogen at a temperature on the order of 800°C for a duration on the order of two minutes in an RTA system or for on the order of 30 minutes in a furnace.

Referring to FIG. 2D, gate electrode material 110 is deposited over high-K layer 108. Gate electrode 110 preferably comprises metal. The metal chosen may need to be matched to the dielectric layer 108. For example, gate electrode 110 may comprise a stack of tungsten, aluminum, or copper along with a barrier TiN layer. In the preferred embodiment, gate electrode 110 comprises a layer of tungsten (W) having a thickness on the order of 800 Angstroms overlying a layer of titanium-nitride (TiN) having a thickness on the order of 200 Angstroms.

Finally, gate electrode material 110, high-K layer 108 and silicon-oxynitride layer 106 are patterned and etched to form gate stack 104 as shown in FIG. 2A. Fabrication of transistor 100 is completed by implanting drain extension regions 116, depositing and etching a dielectric to form sidewall spacers 117, and implanting source/drain regions 114.

While the present invention has been described with reference to illustrative embodiments, this description is not intended to be construed in a limiting sense. Various modifications and combinations of the illustrative embodiments, as well as other embodiments of the invention will be apparent to persons skilled in the art upon reference to the description.

## Claims

1. A method of fabricating an integrated circuit comprising:
forming a silicon dioxide layer over a semiconductor body;
subjecting said silicon dioxide layer to a remote plasma nitridation for converting said silicon dioxide layer to a silicon-oxynitride layer;
forming a high-k dielectric layer over said silicon-oxynitride layer, said high-K dielectric layer having a dielectric constant greater than 10;
forming a metal layer over said high-K dielectric layer; and
patterning and etching said metal layer, said high-K dielectric layer, and said silicon oxynitride layer to form a gate stack.

2. The method of claim 1, wherein said step of forming said silicon dioxide layer comprises forming a silicon dioxide layer having a thickness less than 20 Angstroms.

3. The method of claim 1 or Claim 2, wherein said step of forming said high-k dielectric layer comprises forming a high-K dielectric layer comprising a material selected from a group of materials consisting of Ta2O5, BaTiO3, TiO2, CeO2, and BST.

4. The method of any preceding claim, wherein said step of forming said metal layer comprises forming a metal layer comprising a tungsten layer overlying a titanium-nitride layer.

5. The method of any preceding claim, wherein said step of subjecting said silicon dioxide layer to remote plasma nitridation comprises subjecting said silicon dioxide layer to remote plasma nitridation using a nitrogen containing precursor selected from a group consisting of N₂ Stet NH₃ or a mixture thereof with an inert gas or an oxidizing gas.

6. The method of any preceding claim, wherein said step of subjecting said silicon dioxide layer to remote plasma nitridation comprises subjecting said silicon dioxide layer to remote plasma nitridation at a pressure in the range of 1 to 50 mTorr.

7. The method of any preceding claim, wherein said step of subjecting said silicon dioxide layer to remote plasma nitridation comprising a plasma density in the range of 1x10¹⁰ to 1x10¹².

8. The method of any preceding claim, wherein said step of subjecting said silicon dioxide layer to remote plasma nitridation comprising a nitrogen flow in the range of 1 to 100 sccm.

9. A MOSFET transistor comprising:
a multi-layer gate dielectric formedoverlying a semiconductor body, said multi-layer gate dielectric comprising a layer of silicon-oxynitride and a layer of an oxygen-containing high dielectric constant material;
a metal stet electrode overlying said multi-layer gate dielectric;
a region on a first side of said gate electrode; and
a stet region on a second side of said gate electrode.

10. The transistor of claim 9, wherein said silicon-oxynitride layer has a thickness less than 20 Angstroms.

11. The transistor of claim 9 or claim 10, wherein said high-dielectric constant layer comprises a material selected from a group consisting of Ta2O5, BaTiO3, TiO2, CeO2, and BST.
